# EUROPEAN PATENT APPLICATION

(11) **EP 4 826 340 A1**
(43) Date of publication of application: **21.10.2026**
(21) Application number: 26171975.1
(22) Date of filing: 13.04.2026
(51) Int. Cl.: G01J 1/46, H04N 5/30, G01J 1/44

(54) **TEMPERATURE-COMPENSATED DIELECTRIC ABSORPTION COMPENSATION FOR TRANSIMPEDANCE AMPLIFIERS**

(30) Priority: 15.04.2025 US 202519179015
(71) Applicant: Avago Technologies International Sales Pte. Limited, Singapore 768923 (SG)
(72) Inventor: Agarwal, Rishi Chandra, Irvine, 92618 (US)
(74) Representative: Dilg, Haeusler, Schindelmann Patentanwaltsgesellschaft mbH

(57) **Abstract**

The present disclosure, in various embodiments, provides a system for compensating dielectric absorption (DA) effects in a transimpedance amplifier (TIA) circuit. The system includes a memory storing temperature-dependent DA characteristics, a temperature monitor, and a digital controller. The digital controller processes temperature data and stored characteristics to generate compensation signals. A compensation current generator produces multiple compensation currents with different time constants based on the compensation signals. The system further includes a photodetector, a reference sensor, filters for signal conditioning, and a TIA. The compensation currents are injected into the TIA input to counteract slow-settling effects caused by DA, resulting in improved settling performance and accuracy of the TIA output signal across varying temperature conditions. There are other embodiments as well.

## Description

### FIELD OF INVENTION

The subject technology is directed to electrical circuits.

### BACKGROUND OF THE INVENTION

In a wide range of analog and mixed-signal electronic systems, capacitive elements are commonly used for signal storage, integration, filtering, and sensing. A problematic phenomenon associated with capacitors is dielectric absorption (DA). DA refers to the tendency of a capacitor to retain and gradually release energy over time, even after being discharged. This behavior results in residual voltage or slow-settling tail currents that can persist after signal transitions, introducing error, distortion, or drift into precision signal paths.

In the past, various approaches have been proposed, but they are inadequate for the reasons explained below. New and improved methods and systems are desired.

### BRIEF DESCRIPTION OF THE DRAWINGS

FIG. 1 illustrates an example embodiment of dielectric absorption compensation circuit system 100 configured to mitigate signal settling effects caused by dielectric absorption in capacitive elements according to embodiments of the subject technology.
FIG. 2 illustrates an example embodiment of a dielectric absorption compensation circuit system 200 configured to implement current-based compensation across multiple photodetector channels using a shared compensation current generation mechanism according to embodiments of the subject technology.
FIG. 3 illustrates an embodiment of a dielectric absorption compensation circuit system 300 according to embodiments of the subject technology.
FIG. 4 illustrates a circuit diagram of a dielectric absorption compensation system 400 configured to support multiple photodetector (PD) channels with a shared current compensation architecture according to embodiments of the subject technology.
FIG. 5 illustrates the temperature dependence of dielectric absorption characteristics in a capacitive system and demonstrates the value of implementing temperature-calibrated dielectric absorption compensation.

### DETAILED DESCRIPTION OF THE INVENTION

The present disclosure, in various embodiments, provides a system for compensating dielectric absorption effects in a transimpedance amplifier (TIA) circuit. The system includes a memory storing temperature-dependent DA characteristics, a temperature monitor, and a digital controller. The digital controller processes temperature data and stored characteristics to generate compensation signals. A compensation current generator produces multiple compensation currents with different time constants based on the compensation signals. The system further includes a photodetector, a reference sensor, filters for signal conditioning, and a TIA. The compensation currents are injected into the TIA input to counteract slow-settling effects caused by DA, resulting in improved settling performance and accuracy of the TIA output signal across varying temperature conditions. There are other embodiments as well.

DA is particularly detrimental in circuits that rely on high-speed or high-accuracy charge transfer, such as transimpedance amplifiers (TIAs), sample-and-hold circuits, analog-to-digital converters (ADCs), photodetector front-ends, and capacitive sensing systems. In TIAs used for optical sensing, for example, DA in input or feedback capacitors can cause prolonged signal settling and baseline wander, impairing both speed and accuracy. In switched-capacitor circuits, DA can lead to charge leakage errors that degrade linearity and resolution. Similarly, in capacitive touch, bio-sensing, and environmental sensors, DA can compromise the consistency and repeatability of sensor readings.

The impact of DA is further complicated by its strong dependence on temperature. As temperature changes, both the magnitude of dielectric absorption and the associated time constants vary significantly, leading to unpredictable behavior unless appropriately compensated.

Existing approaches to mitigating DA effects have several limitations. One common method is the selection of specialty low-DA dielectric materials, which often come at increased cost, limited availability, or performance tradeoffs in other areas such as size or leakage. Another technique involves circuit-level compensation using fixed calibration schemes or pre-characterized lookup tables; however, such methods are typically static and cannot adapt to dynamic changes in system temperature or operating conditions. Some systems rely on post-processing or digital correction, which may be too slow or imprecise for real-time analog signal chains.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the subject technology is not intended to be limited to the embodiments presented, but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus comprising a device, which comprises: a photodetector configured to generate an input current in response to incident light. The device further comprises a reference sensor configured to provide a reference current. The device further comprises a compensation section configured to provide a compensation current. The compensation current is generated using at least a characteristic data and a temperature value, the characteristic data is associated with a dependence between dielectric absorption and a temperature. The device further comprises a transimpedance amplifier (TIA) comprising a first input and a second input. The TIA is configured to provide an output voltage using currents received at the first input and the second input. The first input is coupled to the input current and the compensation current. The second input is coupled to the reference current.

Implementations may include one or more of the following features. The photodetector comprises a photodiode. The reference sensor comprises a reference capacitor coupled to a reference voltage node. The compensation section comprises a processor and a digital-to-analog converter (DAC), the processor being configured to generate a compensation value using at least the characteristic data and the temperature value, the DAC being configured generate a control signal using the compensation value. The compensation section further comprises a voltage-to-current converter configured to generate the compensation current using the control signal. The compensation section comprises a temperature monitor configured to provide the temperature value. The compensation section comprises a memory configured to store the characteristic data, the characteristic data being predefined in a calibration process. The characteristic data comprises a plurality of current-time constant pairs associated with the dependence. The device further comprises a filter coupled to the TIA for removing electromagnetic interference.

According to another embodiment, the subject technology provides a device that comprises a photodetector configured to generate an input current in response to incident light. The device further comprises a reference sensor configured to provide a reference current. The device further comprises a compensation section comprising a plurality of resistor and capacitor pairs and configured to provide a compensation current. The device further comprises a transimpedance amplifier (TIA) comprising a first input and a second input, the TIA being configured to provide an output voltage using currents received at the first input and the second input, the first input being coupled to the input current and the compensation current, the second input being coupled to the reference current.

Implementations may include one or more of the following features. The plurality of resistor and capacitor pairs are calibrated based on a system temperature. The photodetector comprises a photodiode. The reference sensor comprises a reference capacitor coupled to a reference voltage node. The device further comprises a filter coupled to the TIA for removing electromagnetic interference.

According to yet another embodiment, the subject technology provides a device, which comprises a plurality of photodetectors configured to generate a plurality of input currents in response to incident light. The device further comprises a compensation section configured to provide a plurality of compensation currents. The plurality of compensation currents is generated using at least a characteristic data and a temperature value, the characteristic data being associated with a dependence between dielectric absorption and a temperature. The device further comprises a selector configured to provide a first current and a second current, the first current being based on a plurality of currents and the plurality of compensation currents. The device further comprises a transimpedance amplifier (TIA) comprising a first input and a second input, the TIA being configured to provide an output voltage using currents received at the first input and the second input, the first input being coupled to the first current, the second input being coupled to the second current.

Implementations may include one or more of the following features. The compensation section comprises a digital-pulse controller configured to generate a control signal based on the temperature value and the characteristic data. The device further comprises a non-volatile memory configured to store the characteristic data associated with dielectric absorption behavior across temperature. The compensation section includes a current buffer or current mirror configured to replicate a compensation current for a selected photodetector channel. The selector comprises a multiplexer configured to selectively couple one of the plurality of photodetectors to the first input of the TIA. Each of the photodetectors is coupled to a corresponding radio frequency interference (RFI) filter comprising a resistor and a capacitor

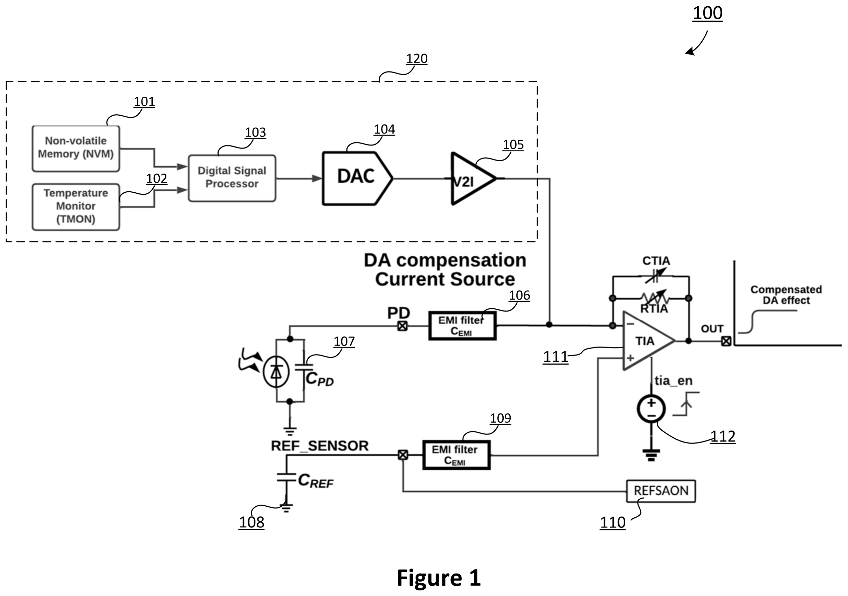

FIG. 1 illustrates an example embodiment of dielectric absorption compensation circuit system 100 configured to mitigate signal settling effects caused by dielectric absorption in capacitive elements according to embodiments of the subject technology. This diagram is merely an example, which should not unduly limit the scope of the claims. One of ordinary skill in the art would recognize many variations, alternatives, and modifications. For example, system 100 provides real-time generation of temperature-dependent compensation currents to improve the settling behavior and precision of a transimpedance amplifier (TIA) signal chain.

System 100 includes compensation section 120 comprising various components that operate together to produce a calibrated current signal. For example, the term "compensation section" broadly refers to any combination of hardware, firmware, software, circuitry, logic, or functional components that are configured to generate, adjust, or apply one or more compensation signals. The compensation section may operate based on predetermined parameters, calibration data, sensed environmental conditions (e.g., temperature), timing information, or any combination thereof. In certain embodiments, the compensation section may include one or more of: a processor, a digital signal controller, a digital-to-analog converter (DAC), a voltage-to-current converter (V2I), a memory, an analog signal generator, or programmable logic. The compensation section may be configured to output current, voltage, or other control signals to reduce or mitigate effects such as dielectric absorption, signal distortion, drift, or other time-dependent or environment-sensitive circuit phenomena. The compensation section may be implemented in analog, digital, or mixed-signal form and may be integrated on-chip with other components (e.g., transimpedance amplifiers or sensor interfaces) or disposed separately in whole or in part. In some implementations, the compensation section may generate signals in response to real-time measurements (e.g., temperature, voltage, or delay) and modify its output accordingly. Unless explicitly stated otherwise, the compensation section is not limited to any specific circuit topology, signal format, signal domain, or processing technique, and may be configured to operate across a wide range of applications involving precision sensing, amplification, or signal conditioning.

As an example, memory 101 is configured to store calibration data, including a set of dielectric absorption parameters such as current-time constant pairs-e.g., (I₁,*τ*₁) through (I_{N},*τ*_{N})-which are pre-characterized across a range of temperatures. Depending on the implementation memory101 may be implemented using any suitable non-transitory storage medium capable of retaining stored data without requiring continuous power. In various embodiments, memory 101 may include, but is not limited to, electrically erasable programmable read-only memory (EEPROM), flash memory, ferroelectric RAM (FRAM), magnetoresistive RAM (MRAM), phase-change memory (PCM), one-time programmable (OTP) memory, or other forms of persistent semiconductor memory. Memory 101 is configured to store compensation parameters, including pre-characterized or calibrated values associated with dielectric absorption behavior over a range of temperatures. In some implementations, the NVM may store one or more look-up tables, compensation vectors, digital waveform templates, or mathematical models. The stored data may be written during manufacturing, field calibration, or through in-system updates. Although illustrated as a dedicated component, in alternative embodiments, the functionality of memory 101 may be implemented as a portion of a shared system memory, such as embedded memory within a microcontroller, digital signal processor, or system-on-chip (SoC) device.

A temperature monitor (TMON) 102 is provided to measure the system temperature in real time. For example, the term "temperature monitor" refers broadly to any component, circuit, module, or system configured to detect, measure, sense, estimate, or otherwise provide information indicative of temperature. The temperature monitor may be implemented using analog, digital, or mixed-signal techniques, and may include one or more sensors, signal conditioning circuits, digital interfaces, or software algorithms. The temperature monitor may comprise, but is not limited to, a bandgap-based sensor, resistance temperature detector (RTD), thermistor, diode-based sensor, junction temperature sensor, thermal couple, infrared sensor, or any other suitable temperature-sensitive element. The temperature monitor may generate an analog voltage or current, a digital code, or a data structure representing the sensed temperature. In various embodiments, the temperature monitor may be located on-chip, off-chip, or distributed across multiple regions of a system. The monitor may measure ambient temperature, local chip temperature, substrate temperature, or temperature of a specific component or circuit. In some implementations, the temperature monitor may be integrated with other system functions such as power management, calibration, or thermal protection. The temperature data produced by the temperature monitor may be used in real time or stored for later processing, and may serve as an input to other functional blocks, such as compensation circuits, control logic, or software algorithms. Unless expressly stated otherwise, the term "temperature monitor" is intended to encompass any implementation suitable for providing temperature-related information, regardless of the sensing technology, level of integration, or precision.

Memory 101 and TMON 102 provide data inputs to digital signal processor (DSP) 103. Based on the measured temperature and stored compensation data, DSP 103 generates digital control signals that are provided to a digital-to-analog converter 104. For example, the term "digital signal processor" refers broadly to any processing element, logic, circuit, controller, or computing unit configured to perform digital signal computation, manipulation, or control functions. A DSP may be implemented using hardware, software, firmware, or any combination thereof, and may be embodied in a dedicated DSP core, a general-purpose microcontroller, an application-specific integrated circuit (ASIC), a field-programmable gate array (FPGA), a programmable logic device (PLD), or as part of a system-on-chip (SoC) architecture. The digital signal processor may receive one or more inputs such as digital signals, stored data (e.g., calibration values), sensor outputs (e.g., temperature measurements), or user-defined parameters, and may generate one or more outputs such as control words, compensation signals, waveform parameters, or digital configuration commands. Unless stated otherwise, the term "digital signal processor" or "DSP" is intended to include any functional element or processing entity capable of executing or controlling digital signal-related operations, regardless of architecture, implementation, or physical integration.

The DAC 104 outputs an analog voltage signal representative of a desired compensation current magnitude. This analog signal is then converted to a current signal by voltage-to-current (V2I) converter 105. The output of the V2I converter is applied to node 106 and merged with the sensing current path, as described below. For example, the term "voltage-to-current (V2I) converter" refers broadly to any circuit, component, system, or functional block configured to generate an electrical current signal in response to, and typically proportional to, an input voltage signal. The V2I converter may be implemented using analog circuitry, digital control logic, or a combination thereof, and may operate in continuous-time, discrete-time, or pulse-based modes. The V2I converter may be configured to receive an input voltage from a digital-to-analog converter, control logic, a sensor, or any other voltage-generating source, and convert that input into a corresponding current suitable for driving analog components such as transimpedance amplifiers (TIAs), signal conditioning networks, or compensation paths. The output current may be linear or non-linear with respect to the input voltage, depending on the application. For example, a V2I converter may be implemented on the same chip as the associated circuitry or in a separate integrated circuit or module. Unless explicitly stated otherwise, the term "voltage-to-current converter" encompasses all implementations capable of translating a voltage signal into a current output, irrespective of circuit topology, linearity, or operating domain.

System 100 further includes photodetector 107 configured to generate a current in response to incident light. For example, photodetector 107 comprises a parasitic capacitance C_{PD}. In various embodiments, the photodetector may include, but is not limited to, a photodiode, avalanche photodiode (APD), phototransistor, photoconductor, photovoltaic cell, quantum dot sensor, PIN diode, or other light-sensitive elements. The photodetector may be configured to produce an output in the form of a current, voltage, resistance change, or digital signal depending on the application and system design. The output current of the photodetector 107 is coupled electromagnetic interference (EMI) filter 106 that includes, for example, a series resistor and a shunt capacitor to attenuate high-frequency noise components. For example, the term "electromagnetic interference (EMI) filter" refers broadly to any circuit, component, structure, or combination thereof that is configured to suppress, attenuate, or reduce electromagnetic noise or interference present in a signal path or power supply line. An EMI filter may be used to isolate sensitive circuits from external noise sources or to prevent high-frequency interference generated by a system from propagating to other components or external interfaces.

In various implementations, reference sensor 108 is provided to mimic the electrical characteristics of the photodetector path in the absence of light. The reference sensor includes a reference capacitor C_{REF}, and is coupled to system ground 108. The output of reference sensor 108 is coupled EMI filter 109, which is coupled to a reference enable circuit 112. The reference signal path is completed by a trace 110, which connects to the non-inverting input of transimpedance amplifier 111.

TIA 111 receives two input signals: a first input (inverting terminal) receives a combined current at node 106, which includes both the photodetector current and the DA compensation current; a second input (non-inverting terminal) receives a stable reference voltage, provided by the reference sensor path through EMI filter 109 and enable circuit 112.

For example, TIA 111 further includes a programmable feedback resistor (RTIA) and capacitor (CTIA) coupled between its output and the inverting input, forming a feedback network that establishes the gain and bandwidth characteristics of the amplifier. The output of the TIA is shown producing a compensated DA effect, indicating that the injected compensation current has corrected the slow-settling dielectric response.

For example, enable circuit 112 provides a bias or reference voltage (e.g., 0.5 V) to the non-inverting terminal of the TIA 111 and may be controlled via a signal such as tia_en. For example, the REFSAON block provides an always-on reference voltage to ensure the stability of the reference path.

In operation, the compensation section 120 dynamically adjusts the compensation current based on real-time temperature readings from the TMON 102 and previously stored calibration data in the NVM 101. DSP 103 calibrates the compensation waveform accordingly, and the resulting current pulse-shaped according to temperature-dependent DA behavior-is delivered to the TIA input via the V2I path.

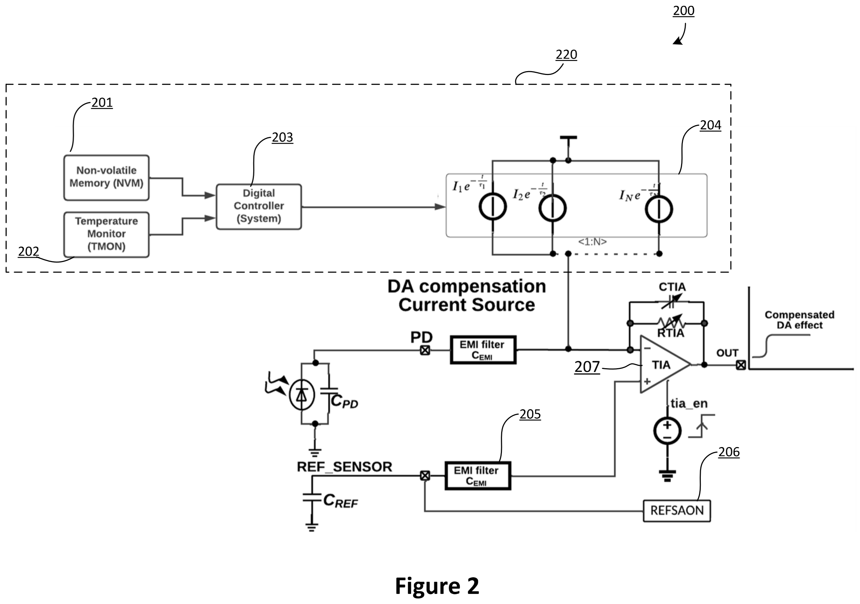

FIG. 2 illustrates an example embodiment of a dielectric absorption compensation circuit system 200 configured to implement current-based compensation across multiple photodetector channels using a shared compensation current generation mechanism according to embodiments of the subject technology. This diagram is merely an example, which should not unduly limit the scope of the claims. One of ordinary skill in the art would recognize many variations, alternatives, and modifications.

System 200 includes a memory 201 and a temperature monitor 202. For example, these components provide input data to a digital controller 203, which may be implemented as a microcontroller, digital signal processor, or other control logic. Memory 201 stores pre-characterized compensation data, such as current amplitude and decay constants, while temperature monitor 202 provides a real-time measurement of the operating temperature of the system.

Digital controller 203 processes the temperature data and retrieves compensation parameters from memory 201. Based on this information, controller 203 provides digital control signals to configure a DA compensation current source 204. This current source includes a set of controlled current-generating elements-each represented by a decaying exponential current pulse-designed to emulate and cancel specific time-constant components of the DA response. For example, the DA compensation current source may include N stages, with each stage generating a current pulse are temperature-calibrated parameters.

Digital controller 203 and current source 204 are provided at compensation section 220, which provides DA correction. The output of the DA compensation current source is applied to node 207, which also receives signal current from the sensing path.

The sensing path includes photodetector 107 configured to generate a photocurrent in response to incident light. For example, this photocurrent flows through an EMI filter 207, which reduces high-frequency interference before reaching the input of TIA 207. The photodetector is modeled with a parasitic capacitance C_{PD}, representing the dielectric component that exhibits DA behavior.

A reference sensor is also provided and comprises a reference capacitor C_{REF} coupled to the system ground. The reference path signal is filtered by a second EMI filter 205 and coupled to the non-inverting input of TIA 207. For example, TIA 207 is configured to receive two differential inputs: the inverting input receives the sum of the photodetector current and the DA compensation current; the non-inverting input receives the reference voltage, supplied through EMI filter 205 and stabilized by a reference enable circuit 206 (e.g., labeled REFS AON), which maintains a steady reference potential (e.g., 0.5 V).

TIA 207 includes a feedback network comprising a programmable feedback resistor (RTIA) and programmable feedback capacitor (CTIA), which define the gain and temporal behavior of the amplifier. The output node of the TIA provides a voltage signal that reflects the compensated result of the photodetector signal with DA effects removed.

For example, in operation, the compensation current dynamically counteracts DA-induced tail currents based on real-time temperature readings. The use of exponentially decaying current pulses enables precise matching to the time-domain response of the dielectric absorption. In various implementations, system 200 supports on-chip implementation, low-power operation, and scalable compensation resolution, providing a robust solution for improving analog front-end settling time and accuracy in precision sensing applications.

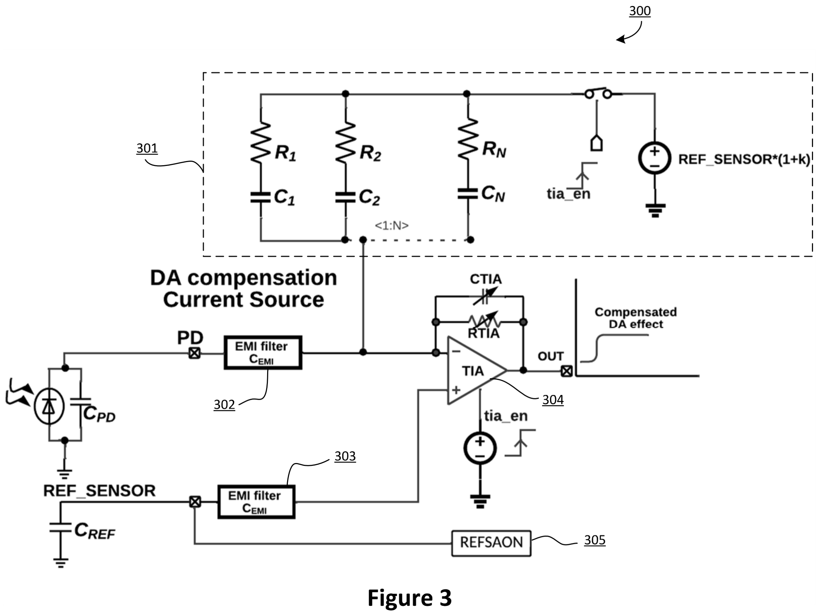

FIG. 3 illustrates an embodiment of a dielectric absorption compensation circuit system 300 according to embodiments of the subject technology. This diagram is merely an example, which should not unduly limit the scope of the claims. One of ordinary skill in the art would recognize many variations, alternatives, and modifications. As shown, system 300 employs a resistor-capacitor (RC) network to generate a series of compensation current pulses for mitigating dielectric absorption effects in a TIA-based sensor interface.

The system 300 includes a DA compensation current source comprising a plurality of RC segments, each formed by a series-connected resistor and capacitor pair-(R₁, C₁), (R₂, C₂), through (Rₙ, Cₙ). For example, RC segments are arranged in parallel and collectively produce a composite current signal exhibiting multiple exponential decay components. The values of the resistors and capacitors are selected to match the dominant time constants associated with dielectric absorption effects observed in the sensing circuitry.

The compensation current source may be configured as part of compensation section 301, which also includes a reference signal source configured to deliver a voltage pulse greater than the baseline reference sensor signal level. For example, the pulse is labeled as REF_SENSOR × (1 + k), where k is a predetermined offset factor. This pulse, when applied across the RC segments, initiates current transients that emulate and cancel the slow-settling behavior caused by dielectric absorption.

A photodetector with parasitic capacitance C_{PD} is included to detect optical signals. The output of the photodetector is routed through an EMI filter 302, comprising at least a capacitor C_{EMI}, which suppresses high-frequency noise and interference from corrupting the analog signal path.

A reference sensor, modeled by a reference capacitor C_{REF}, is coupled to ground and used to generate a baseline voltage for differential signal comparison. The reference sensor is also routed through EMI filter 303. The reference signal path may be enabled and controlled by a reference enable signal 305, labeled REFSAON, which activates or deactivates the reference path as needed for calibration, pre-charge, or sampling.

Both the photodetector and reference sensor outputs are fed into TIA 304. TIA 304 includes a feedback resistor (R_{TIA}) and a feedback capacitor (C_{TIA}) that define its gain and bandwidth characteristics. The TIA receives the photodetector signal and the temperature-compensated DA cancellation current at its inverting input, while the non-inverting input receives the reference signal from the REFSENSOR path.

The output of TIA 304 provides a signal in which the effects of dielectric absorption have been compensated, as represented by the labeled "Compensated DA effect." This output reflects the corrected photocurrent response with reduced long-tail settling caused by dielectric absorption in the system's capacitive nodes.

For example, the values of the RC segments (R₁, C₁) through (Rₙ, Cₙ) are selected based on the characterization of the system across a range of temperatures. These values may be fixed, digitally programmable, or dynamically tuned depending on temperature or calibration data. In operation, the RC-generated current pulses simulate the inverse of the DA effect and are injected into the sensing node to actively cancel the spurious DA-induced currents.

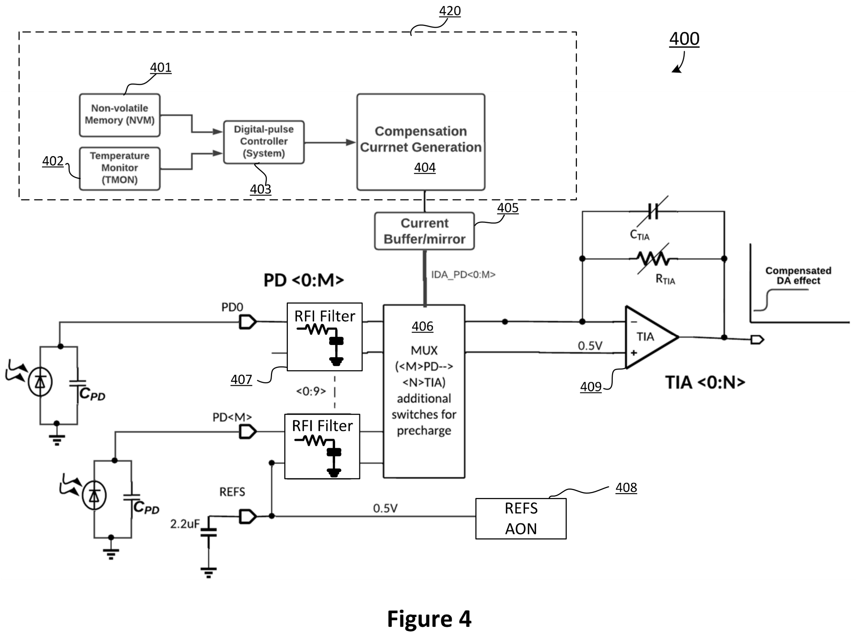

FIG. 4 illustrates a circuit diagram of a dielectric absorption compensation system 400 configured to support multiple photodetector channels with a shared current compensation architecture according to embodiments of the subject technology. This diagram is merely an example, which should not unduly limit the scope of the claims. One of ordinary skill in the art would recognize many variations, alternatives, and modifications. For example, system 400 may address DA effects commonly found in capacitive nodes of TIA-based sensor front ends, particularly in applications with multiple PDs exhibiting similar DA behavior.

System 400 includes memory 401 and temperature monitor 402. For example, these components are communicatively coupled to digital-pulse controller 403. Memory 401 stores calibration parameters including current magnitudes and time constants associated with dielectric absorption compensation, while the TMON 402 provides real-time temperature information that affects the DA response characteristics.

Digital-pulse controller 403 receives temperature and calibration data and outputs a control signal to a compensation current generation block 404, which generates one or more current pulses based on the input parameters and includes multiple calibrated RC segments to shape the decay profile of the generated current. The output of the compensation current generator 404 is provide to current buffer/mirror 405, which enables the generated current to be replicated and distributed to multiple PD input channels. For example, the term "current buffer" refers broadly to any circuit, device, module, or functional block that is configured to replicate, isolate, scale, or distribute an input current to one or more output nodes without substantially loading or affecting the source of the current. For example, a current buffer may be implemented as a discrete circuit, an integrated component, or as part of a system-on-chip or analog front-end. Unless otherwise explicitly stated, the term "current buffer" is intended to encompass all configurations capable of accepting a current input and providing a corresponding output current while preserving desired signal characteristics or isolation properties, regardless of implementation details or specific application context.

The output of the current buffer 405 is coupled to a selector (e.g., multiplexer MUX) 406 that selectively couples current sources and PD inputs to a set of TIAs. For example, MUX includes multiple switches capable of performing pre-charge operations and provides flexible routing between M photodetectors and N transimpedance amplifiers, where M and N may differ. For example, the MUX facilitates the sharing of a common compensation current among PD channels where the dielectric absorption response is known to be similar. For example, the term "multiplexer" refers broadly to any circuit, device, module, or functional block that is configured to selectively route one or more input signals to one or more output nodes based on a control signal or logic state. A multiplexer may operate in the analog or digital domain, and may be implemented using discrete components, integrated circuits, programmable logic, or embedded processing elements. Unless expressly stated otherwise, the term "multiplexer" is intended to encompass any switching or signal selection mechanism capable of directing signal flow between multiple input and output ports, regardless of implementation style, signal type, level of integration, or intended use case.

In an embodiment, each photodetector includes an associated capacitance C_{PD} and is coupled to an RFI filter 407. These filters are configured to suppress high-frequency noise and electromagnetic interference from the photodetector signal paths. The PD signals are routed through the MUX 406 to the inverting input of a corresponding TIA 409.

The system also includes a reference sensor (REFS) that mimics the structure of the photodetector and is connected through a 2.2 µF capacitor to a second RFI filter 407. The reference sensor path is enabled by a dedicated control block 408 labeled REFS AON, which provides a stable reference signal to the non-inverting input of each TIA. Both the PD and reference sensor paths are biased to a reference voltage of approximately 0.5V, ensuring consistent differential operation.

For example, each TIA 409 includes a feedback resistor (e.g., R_{TIA}) and capacitor (e.g., C_{TIA}) that define the gain and temporal response of the amplifier. The output of the TIA provides a signal that reflects the photodetector input corrected for dielectric absorption effects, achieved through precise current injection at the TIA's inverting input.

Compensation section 420 includes the memory 401, temperature monitor 402, controller 403, current generator 404, and current buffer 405. Compensation section 420 is configured to provide real-time adjustment of the compensation current based on environmental temperature and pre-stored calibration data. Depending on the implementation, each compensation current IDA may be scaled or modulated per PD channel to enhance compensation effectiveness.

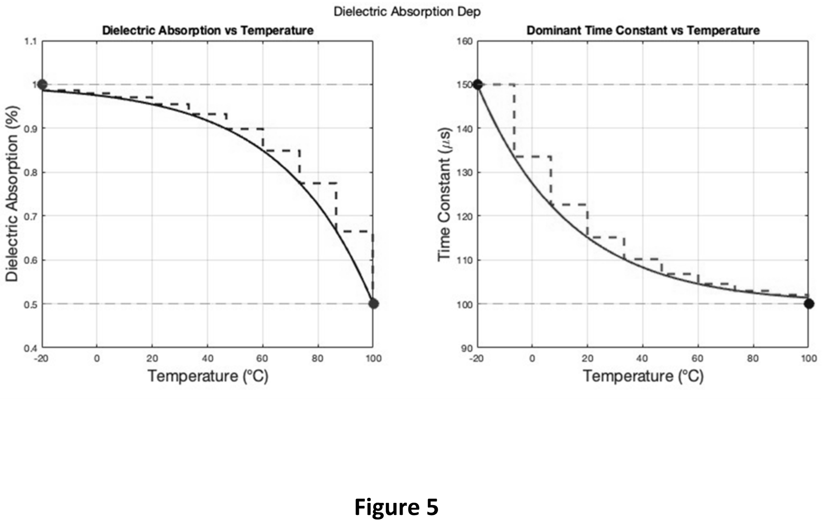

FIG. 5 illustrates the temperature dependence of dielectric absorption characteristics in a capacitive system and demonstrates the value of implementing temperature-calibrated dielectric absorption compensation.

The graph on the left side of Figure 5 shows the variation of dielectric absorption percentage as a function of temperature. The horizontal axis represents the system temperature in degrees Celsius (°C), while the vertical axis shows the measured dielectric absorption in percentage (%). The curve displayed in this plot indicates that dielectric absorption decreases progressively with increasing temperature in a nonlinear fashion. For instance, the dielectric absorption values decline from approximately 1.0% at low temperatures to around 0.5% at high temperatures, such as 100°C. This increase demonstrates that DA behavior becomes more pronounced at lower temperatures, adversely impacting signal integrity and settling accuracy in analog front-end systems if not properly corrected.

The right-hand graph illustrates the change in the dominant dielectric absorption time constant with temperature. The horizontal axis again corresponds to temperature in degrees Celsius, while the vertical axis indicates the time constant in microseconds (µs). The curve in this graph reveals that the dominant time constant decreases as temperature increases. Specifically, the time constant transitions from approximately 150 µs at lower temperatures to nearly 100 µs at higher temperatures. This trend implies that the DA effect decays more quickly at higher temperatures, whereas at lower temperatures, the DA-induced current persists for a longer duration. It is to be appreciated that the relationships described herein are provided for exemplary purposes, and that the relationship between temperature, time constant, and dielectric absorption can vary depending on various factors, such as dielectric material properties, ambient conditions, and/or the like.

The data shown in both plots confirm that DA behavior is temperature dependent. These results illustrate the use of DA compensation, as provided in various embodiments of the subject technology, a calibration-based compensation method in which the DA characteristics of the system are first characterized across a range of temperatures. The resulting values may be divided into segments or operating ranges depending on the required accuracy and resolution. The segmented or interpolated values can then be normalized to a nominal reference, such as room temperature, and stored in non-volatile memory. During operation, a system temperature monitor measures the current temperature in real time. Based on the measured temperature, the system retrieves corresponding DA compensation parameters and dynamically adjusts the compensation current and its decay time constant. This real-time scaling ensures accurate and consistent cancellation of DA effects under varying thermal conditions.

While the above is a full description of the specific embodiments, various modifications, alternative constructions and equivalents may be used. Therefore, the above description and illustrations should not be taken as limiting the scope of the subject technology which is defined by the appended claims.

## Claims

1. A device comprising:
a photodetector configured to generate an input current in response to incident light;
a reference sensor configured to provide a reference current;
a compensation section configured to provide a compensation current, wherein the compensation current is generated using at least a characteristic data and a temperature value, the characteristic data being associated with a dependence between dielectric absorption and a temperature; and
a transimpedance amplifier (TIA) comprising a first input and a second input, the TIA being configured to provide an output voltage using currents received at the first input and the second input, the first input being coupled to the input current and the compensation current, the second input being coupled to the reference current.

2. The device of claim 1, wherein
the photodetector comprises a photodiode.

3. The device of claim 1 or 2, wherein
the reference sensor comprises a reference capacitor coupled to a reference voltage node.

4. The device of any one of the claims 1 to 3, wherein
the compensation section comprises a processor and a digital-to-analog converter (DAC), the processor being configured to generate a compensation value using at least the characteristic data and the temperature value,
the DAC being configured generate a control signal using the compensation value.

5. The device of claim 4, wherein
the compensation section further comprises a voltage-to-current converter configured to generate the compensation current using the control signal.

6. The device of any one of the claims 1 to 5, wherein
the compensation section comprises a temperature monitor configured to provide the temperature value.

7. The device of any one of the claims 1 to 6, wherein
the compensation section comprises a memory configured to store the characteristic data, the characteristic data being predefined in a calibration process.

8. The device of any one of the claims 1 to 7, wherein
the characteristic data comprises a plurality of current-time constant pairs associated with the dependence.

9. The device of any one of the claims 1 to 8, further comprising
a filter coupled to the TIA for removing electromagnetic interference.

10. A device comprising:
a photodetector configured to generate an input current in response to incident light;
a reference sensor configured to provide a reference current;
a compensation section comprising a plurality of resistor and capacitor pairs and configured to provide a compensation current; and
a transimpedance amplifier (TIA) comprising a first input and a second input, the TIA being configured to provide an output voltage using currents received at the first input and the second input, the first input being coupled to the input current and the compensation current, the second input being coupled to the reference current.

11. The device of claim 10, further comprising at least one of the following features:
(A) the plurality of resistor and capacitor pairs are calibrated based on a system temperature;
(B) the photodetector comprises a photodiode:
(C) the reference sensor comprises a reference capacitor coupled to a reference voltage node.

12. The device of claim 10 or 11, further comprising
a filter coupled to the TIA for removing electromagnetic interference.

13. A device comprising:
a plurality of photodetectors configured to generate a plurality of input currents in response to incident light;
a compensation section configured to provide a plurality of compensation currents, wherein the plurality of compensation currents is generated using at least a characteristic data and a temperature value, the characteristic data being associated with a dependence between dielectric absorption and a temperature;
a selector configured to provide a first current and a second current, the first current being based on a plurality of currents and the plurality of compensation currents; and
a transimpedance amplifier (TIA) comprising a first input and a second input, the TIA being configured to provide an output voltage using currents received at the first input and the second input, the first input being coupled to the first current, the second input being coupled to the second current.

14. The device of claim 13, wherein
the compensation section comprises a digital-pulse controller configured to generate a control signal based on the temperature value and the characteristic data.

15. The device of claim 13 or 14, further comprising at least one of the following features:
(A) the device further comprises a non-volatile memory configured to store the characteristic data associated with dielectric absorption behavior across temperature;
(B) the compensation section includes a current buffer or current mirror configured to replicate a compensation current for a selected photodetector channel;
(C) the selector comprises a multiplexer configured to selectively couple one of the plurality of photodetectors to the first input of the TIA;
(D) each of the photodetectors is coupled to a corresponding radio frequency interference, RFI, filter comprising a resistor and a capacitor.
